# FASCICULE DE BREVET EUROPEEN

(11) **EP 0 869 619 B1**
(45) Date de publication et mention de la délivrance du brevet: **05.07.2006**
(21) Numéro de dépôt: 98200955.7
(22) Date de dépôt: 26.03.1998
(51) Int. Cl.: H03L 7/081, H03L 7/183

(54) **Circuit intégré comportant une boucle de contrôle de phase**
Integrierte Schaltung mit Phasenregelschleife
Integrated circuit comprising a phase controlled loop

(30) Priorité: 02.04.1997 FR 9704000
(43) Date de publication de la demande: 07.10.1998
(73) Titulaire: Koninklijke Philips Electronics N.V., 5621 BA Eindhoven (NL)
(72) Inventeur: Marie, Hervé, 75008 Paris (FR)
(74) Mandataire: van Oudheusden-Perset, Laure E.

(56) Documents cités:
- US-A- 4 351 001
- US-A- 4 769 705
- US-A- 5 230 013
- US-A- 5 565 928
- DHOORIA K S ET AL: "THREE-PHASE SIGNAL GENERATION FROM A SINGLE-PHASE REFERENCE SIGNAL" MEASUREMENT SCIENCE AND TECHNOLOGY, vol. 2, no. 7, 1 juillet 1991, pages 682-683, XP000241393
- SATORU TANOI ET AL: 'A 250-622 MHz Deskew and Jitter-Suppressed Clock Buffer Using Two-Loop Architecture' IEICE TRANS. ELECTRON. vol. E79-C, no. 7, Juillet 1996, pages 898 - 904

## Description

La présente invention concerne un circuit intégré comportant, entre autres, un montage avec une boucle de contrôle de phase comprenant un oscillateur muni d'une sortie pour fournir un signal dont la fréquence est réglable par une tension appliquée à une entrée de réglage, un diviseur muni d'une entrée reliée à la sortie de l'oscillateur et d'une sortie pour fournir un signal dont la fréquence est divisée par rapport à celle d'un signal appliqué à son entrée, et un comparateur de phase muni de deux entrées, dont l'une est destinée à recevoir un signal de référence et l'autre est reliée à la sortie du diviseur, et d'une sortie reliée à l'entrée de réglage de l'oscillateur via un filtre, et un déphaseur muni d'une sortie et d'une entrée reliée à la sortie de l'oscillateur et de moyens pour délivrer sur sa sortie un signal décalé en phase par rapport au signal sur son entrée.

L'invention s'applique lorsqu'on a besoin de deux signaux à une fréquence multiple l'un de l'autre et dont les transitions soient parfaitement en phase. Elle s'applique, entre autres, à un circuit d'interface pour écran à cristaux liquides, pour générer la fréquence pixel à partir du signal d'horloge lignes.

Un circuit qui génère deux signaux dont les transitions sont en phase est connu du document US 5,036,297. Dans le circuit de ce document, un oscillateur est suivi par une ligne à retard à prises, dont une des prises est choisie par un circuit de sélection, en fonction d'une comparaison de phase entre une référence et le signal de sortie.

Un circuit qui génère deux signaux dont les transitions sont en phase est aussi connu du document US-A-4 351 001. Ce circuit met en oeuvre une double boucle à verrouillage de phase.

L'objet de l'invention est d'obtenir un circuit qui délivre deux signaux dont l'un est à une fréquence multiple de celle de l'autre et dont les transitions soient parfaitement en phase, et dont le déphasage par rapport à une horloge reste constant lorsque la fréquence des signaux varie. Le déphasage devrait idéalement avoir les propriétés suivantes : être programmable de 0 à 360°, fonctionner indifféremment sur plusieurs décades de la fréquence, et apporter une contribution réduite au bruit de phase. Dans les montages de l'art antérieur, où l'on utilise une ligne à retard, celle ci apporte un décalage d'un temps donné, qui doit être modifié lorsque la fréquence varie.

A cet effet, le montage comprend en outre un module de re-synchronisation, comprenant une entrée d'horloge reliée à la sortie du déphaseur et une entrée de signal reliée à la sortie du diviseur. Cet objet est obtenu dans la présente invention par un circuit integré tel que décrit dans la revendication 1.

Dans un mode de réalisation particulier, le module de re-synchronisation est une bascule de type D.

Dans un autre mode de réalisation particulier, le module de re-synchronisation comprend une première bascule de type D, et une seconde bascule du même type, l'entrée d'horloge de la seconde bascule reçoit le même signal d'horloge que celle de la première bascule, après une inversion dans un inverseur, l'entrée de signal de la première bascule constitue l'entrée du module, la sortie de la seconde bascule constitue la sortie du module, et la sortie de la première bascule est reliée à l'entrée de données de la seconde bascule via un multiplexeur commandé par une entrée numérique de contrôle de phase, de façon à sélectionner soit le signal d'entrée soit le signal issu de la première bascule, pour l'appliquer à l'entrée de la seconde bascule.

Avantageusement, le décalage de phase apporté par le déphaseur est programmable, la grandeur de ce décalage étant commandée par un signal de commande appliqué à une entrée de commande.

De préférence, l'oscillateur possède une sortie double qui fournit un signal à deux composantes : un signal principal et un signal annexe déphasé de n/2 par rapport au signal principal, et le déphaseur à déphasage programmable possède une entrée double, reliée à la sortie double de l'oscillateur.

Le déphaseur programmable comporte avantageusement un premier et un deuxième multiplieurs présentant chacun deux entrées et une sortie, et un additionneur à deux entrées, respectivement reliées à la sortie du premier multiplieur et à la sortie du deuxième multiplieur, les premières entrées de chacun des deux multiplieurs constituant ensemble l'entrée double du déphaseur, les secondes entrées de chacun des multiplieurs étant destinées à recevoir chacune un mot numérique de commande, les valeurs de ces deux mots de commande étant telles que la somme de leurs carrés soit constante, chacun des multiplieurs étant muni de moyens pour délivrer un signal qui est le résultat de la multiplication du signal sur sa première entrée par la valeur du mot de commande appliqué à sa seconde entrée.

Dans un tel déphaseur dont le format des mots de commande est de N bits, chaque multiplieur comporte avantageusement un étage de commutation composé de N-1 interrupteurs commandés chacun au moyen de un parmi N-1 bits, un additionneur pour additionner les signaux commandés par chacun des interrupteurs, un module d'inversion relié à la sortie de l'additionneur, et commandé par le bit restant, et N-1 amplificateurs, placés en entrée chacun en amont d'un interrupteur, le gain de chaque amplificateur étant proportionnel au poids, dans le mot de commande, du bit commandant l'interrupteur correspondant.

Ces aspects de l'invention ainsi que d'autres aspects plus détaillés apparaîtront plus clairement grâce à la description suivante d'un mode de réalisation constituant un exemple non limitatif.
La figure 1 représente un circuit intégré comportant un montage avec une boucle de contrôle de phase.
La figure 2 représente une réalisation d'un déphaseur programmable.
La figure 3 représente une réalisation d'un multiplieur, présent dans le déphaseur programmable de la figure 2.
La figure 4 représente une réalisation d'un module de re-synchronisation.

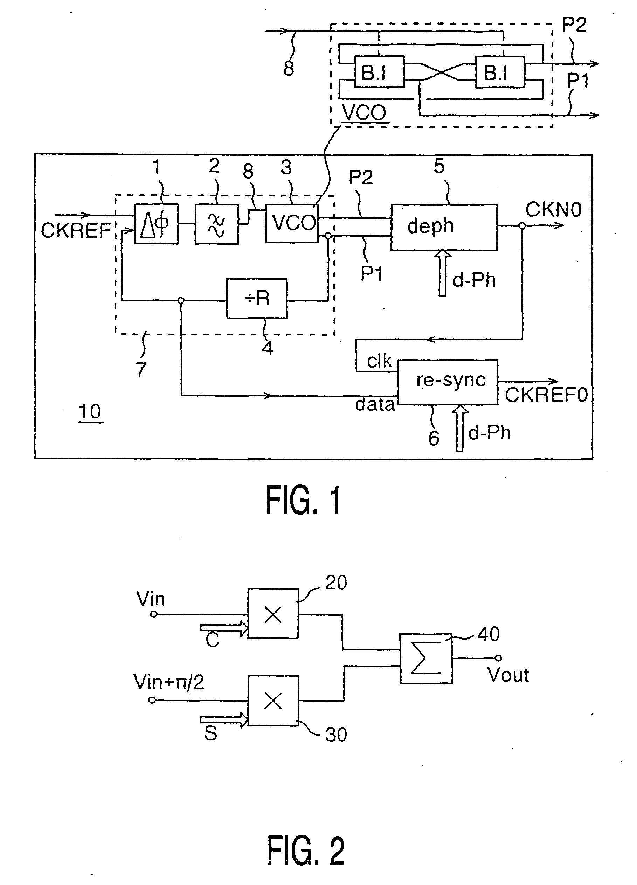

Le circuit intégré 10 représenté par la figure 1 contient un montage qui comporte une boucle de contrôle de phase 7. Cette boucle comprend :
- un oscillateur 3, à fréquence réglable par une tension appliquée au moyen d'une connexion 8, et dont la sortie fournit un signal d'oscillateur à deux composantes : un signal principal P1 et un signal annexe P2, déphasé de π/2 par rapport au signal principal P1. Un oscillateur capable de délivrer de tels signaux est connu de l'homme du métier, il peut être constitué, comme indiqué par le schéma en haut de la figure, au moyen de deux intégrateurs, indiqués "B.I", délivrant un signal symétrique ou équilibré, connectés en cascade avec croisement, c'est-à-dire avec inversion du signal symétrique, et rebouclés l'un sur l'autre. La fréquence est réglée par le signal sur la connexion 8, appliqué à chacun des deux intégrateurs. Deux signaux P1, P2 déphasés de π/2 sont présents aux sorties respectives du premier et du second intégrateur.
- un diviseur 4 qui divise en fréquence le signal P1 dans un rapport R.
- un comparateur de phase 1 qui compare la phase des signaux appliqués à l'une et l'autre de ses deux entrées, dont l'une est reliée à un signal de référence CKREF et l'autre est reliée à la sortie du diviseur de fréquence 4. La tension de sortie du comparateur est appliquée via un filtre passe-bas 2 à la connexion 8, pour régler la fréquence de l'oscillateur 3.

Ce montage comporte en outre un circuit déphaseur 5 dont le déphasage est programmable au moyen d'un signal numérique de commande d-Ph. Ce déphaseur possède une entrée double, reliée aux signaux de sortie P1 et P2 de l'oscillateur 3, et délivre sur sa sortie CKN0 un signal décalé en phase par rapport au signal d'entrée P1/P2, la grandeur de ce décalage étant commandée par le signal de commande d-Ph. Un tel circuit sera décrit plus en détail ci-après.

Enfin, un module 6 dit de re-synchronisation comprend une entrée d'horloge "clk" reliée à la sortie du circuit déphaseur 5, une entrée de signal "data" reliée à la sortie du diviseur 4, et une entrée pour le signal de commande d-Ph. Sa sortie constitue la sortie CKREF0 du montage. Pour ce circuit 6, une bascule D ordinaire peut convenir ; dans ce cas le signal d-Ph n'y est pas utilisé. Toutefois, dans cet emploi, un circuit plus avantageux qu'une bascule D sera décrit en détail plus loin.

La figure 2 représente un déphaseur programmable convenant pour le déphaseur 5 de la figure 1. Un tel déphaseur programmable présente une entrée double destinée à recevoir un signal d'entrée, à déphaser d'une quantité variable, constitué de deux signaux de même fréquence mais déphasés de 90° l'un par rapport à l'autre, par exemple de la forme respectivement A.cosωt et A.sinωt, soit Vin et Vin + π/2. Une deuxième entrée double référencée C et S reçoit un signal numérique dit de commande, et la sortie Vout délivre un signal de sortie de la forme A'.cos(ωt-φ) présentant par rapport au signal d'entrée un déphasage φ défini par le signal de commande.

L'entrée Vin est reliée à une entrée d'un premier multiplieur 20 à et l'entrée Vin+π/2 est reliée à une entrée d'un deuxième multiplieur 30. La sortie du premier multiplieur 20 délivre un signal résultant de la multiplication du signal Vin = A.cosωt reçu sur son entrée, par une valeur numérique C, égale à V.cos(φ), où φ est le déphasage désiré, et V une valeur constante. La sortie du deuxième multiplieur 30 délivre un signal résultant de la multiplication du signal Vin+π/2 = A.sinwt par une valeur S, égale à V.sin(φ). Puisque les valeurs de C et S sont égales respectivement à V.sin(φ) et V.cos(φ), la somme de leurs carrés est constante (puisque sin² + cos² = 1). Le déphaseur comprend enfin un additionneur 40 présentant une première entrée reliée à la sortie du premier multiplieur 20, une deuxième entrée reliée à la sortie du deuxième multiplieur 30, et qui délivre sur sa sortie Vout un signal déphasé, de la forme A.V.cos(ωt-φ), résultant de la somme des signaux reçus sur ses première et deuxième entrées.

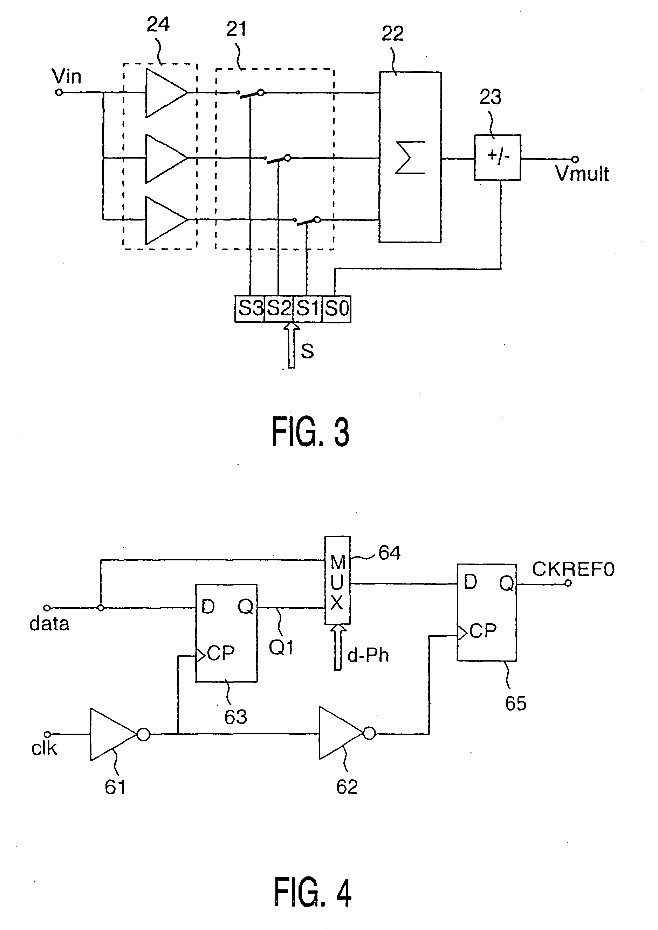

La figure 3 représente schématiquement le multiplieur 20 de la figure 2 (le multiplieur 30 est identique). Le mot de commande C possède ici, à titre d'exemple, 4 bits S0, S1, S2, S3. Ce multiplieur comprend :
- un étage de commutation 21 composé de trois interrupteurs commandés par les trois bits S1,S2,S3
- un additionneur 22 présentant une sortie et 3 entrées reliées chacune à l'un des interrupteurs,
- un module d'inversion 23, qui inverse ou non le signal selon la valeur du bit S0, module dont l'entrée est reliée à la sortie de l'additionneur 22, et dont la sortie constitue la sortie Vmult du multiplieur 20.
- un étage d'amplification 24, composé de 3 amplificateurs, qui est placé à l'entrée du montage, chaque amplificateur recevant le signal Vin d'entrée du multiplieur, les signaux de sortie étant contrôlés chacun par l'un des 3 interrupteurs de l'étage de commutation 21. Le gain du i^{ème} amplificateur (i = 1 à 3) est proportionnel au poids, dans le mot de commande, du bit commandant l'interrupteur qui le suit.

Le circuit de la figure 4 est préférable à une simple bascule D, pour réaliser le module de re-synchronisation 6 de la figure 1. Avec une telle bascule, si le front "clk" est en quasi-coïncidence avec un front "data", le changement d'état ne peut pas être anticipé, et un front risque d'être manqué. Le montage de la figure 4 présente les mêmes entrées et sortie qu'une bascule D, à savoir une entrée de données à re-synchroniser "data", qui correspond à l'entrée "data" de la figure 1, une entrée d'horloge "clk", qui correspond à l'entrée "clk" de la figure 1, et une sortie CKREF0 qui correspond à la sortie CKREF0 de la figure 1. Il comprend une première bascule 63 de type D, et une seconde bascule 65 du même type. L'entrée d'horloge de la bascule 63 reçoit l'horloge "clk", après inversion dans un inverseur 61. L'entrée d'horloge de la bascule 65 reçoit la même horloge, après une seconde inversion dans un inverseur 62. L'entrée de signal de la bascule 63 est reliée à l'entrée "data". La sortie de la bascule 65 est reliée à la sortie CKREF0 et son entrée est reliée à la sortie d'un multiplexeur 64. Ce dernier est commandé par l'entrée numérique de contrôle de phase d-Ph, de façon à sélectionner soit le signal d'entrée "data", soit le signal Q1 issu de la bascule 63. Le signal "data" est d'abord synchronisé dans la bascule 63 sur un front descendant de l'horloge, ce qui donne le signal Q1, puis Q1 est re-synchronisé dans la bascule 65 sur un front montant. Lorsque "data" et "clk" ne sont pas en coïncidence, ce qui correspond à des valeurs particulières du signal d-Ph, le multiplexeur 64 choisit le signal "data", qui est alors re-synchronisé par la bascule 65.

## Revendications

1. Circuit intégré (10) comprenant un montage (7) avec une boucle de contrôle de phase, ledit montage (7) comprenant :
- un oscillateur (3) muni d'une sortie pour fournir un signal de sortie de fréquence réglable via une tension de réglage appliquée à une entrée de réglage,
- un diviseur de fréquence (4) muni d'une entrée reliée à la sortie de l'oscillateur et d'une sortie pour fournir un signal de fréquence divisée,
- un comparateur de phase (1) muni d'une première entrée destinée à recevoir un signal de référence (CKREF), d'une deuxième entrée reliée à la sortie du diviseur de fréquence (4), et d'une sortie reliée à l'entrée de réglage de l'oscillateur (3) via un filtre (2),
- un déphaseur (5) muni d'une entrée reliée à la sortie de l'oscillateur (3) pour délivrer sur sa sortie un signal (CKN0) déphasé par rapport au signal sur son entrée,
**caractérisé en ce que :**
- le déphaseur (5) est muni d'une borne pour recevoir un signal numérique de commande (d-Ph) pour déterminer la valeur du déphasage appliqué au signal sur son entrée,
- le circuit intégré (10) comprend aussi un module de re-synchroaisation (6) présentant une entrée d'horloge (clk) pour recevoir le signal de sortie (CKN0) dudit déphaseur (5), une entrée de données (data) pour recevoir ledit signal de fréquence divisée, une sortie pour délivrer un signal (CKREF0) identique au signal de données (data) sur ladite entrée de données et synchronisé avec le signal (CKN0) sur ladite entrée d'horloge (clk).

2. Circuit intégré selon la revendication 1 **caractérisé en ce que** ledit module de re-synchronisation (6) comprend :
- une première bascule (63) de type D comprenant une entrée d'horloge (CP) reliée à, ladite entrée d'horloge (clk) via un inverseur (61), une entrée de données (D) reliée à ladite entrée de données (data), et une sortie (Q) pour délivrer un signal de sortie (Q1),
- une deuxième bascule (65) de type D comprenant une entrée (CP) reliée à l'entrée d'horloge (CP) de ladite première bascule (63) via un inverseur (62), une entrée de données (D), et une sortie (Q) pour délivrer ledit signal (CKREF0),
- un multiplexeur (64) commandable par une entrée numérique de contrôle de phase (d-Ph) pour appliquer sur l'entrée de données (D) de la deuxième bascule (65) soit le signal de données d'entrée (data) soit le signal de sortie (Q1) de la première bascule (63).

3. Circuit intégré selon la revendication 1 **caractérisé en ce que** le signal de sortie de l'oscillateur (3) comprend un signal principal (P1) et un signal annexe (P2) déphasé de π/2 par rapport au signal principal (P1), ledit déphaseur (5) comprenant :
a) un premier multiplieur (20) pour multiplier ledit signal principal. (P1) avec un premier mot de commande (C),
b) un deuxième multiplieur (30) pour multiplier ledit signal annexe (P2) avec un deuxième mot de commande (S),
c) un additionneur (40) pour additionner les signaux de sortie desdits premier et deuxième multiplieurs (20, 30),
les valeurs desdits premier et deuxième mots de commande (C, S) étant telles que la somme de leurs carrés soit constante.

4. Circuit intégré selon la revendication 3 **caractérisé en ce que** le format des mots de commande étant de N bits, chaque multiplieur (20, 30) comporte :
- un étage de commutation (21) composé de (N-1) interrupteurs commandés chacun au moyen d'un bit pris parmi (N-1) bits desdits mots de commande (C, S),
- un additionneur (22) pour additionner les signaux commandés par lesdits interrupteurs,
- un module d'inversion (23) relié à la sortie de l'additionneur (22), et commandé par le bit restant,
- (N-1) amplificateurs (24) placés chacun en entrée d'un interrupteur, le gain de chaque amplificateur étant proportionnel au poids du bit commandant l'interrupteur correspondant dans le mot de commande (C, S).

## Claims

1. An integrated circuit (10) including an assembly (7) with a phase-control loop, said assembly (7) comprising:
- an oscillator (3) having an output for supplying an output signal whose frequency is controllable by means of a control voltage applied to a control input,
- a frequency divider (4) having an input connected to the output of the oscillator and an output for supplying a signal having a divided frequency,
- a phase comparator (1) having a first input intended to receive a reference signal (CKREF), a second input connected to the output of the frequency divider (4), and an output connected to the control input of the oscillator (3) via a filter (2),
- a phase shifter (5) having an input connected to the output of the oscillator (3) for supplying at its output a signal (CKN0) which is shifted in phase with respect to the signal at its input, **characterized in that**:
- the phase shifter (5) has a terminal for receiving a digital control signal (d-Ph) for determining the value of the phase shift applied to the signal at its input,
- the integrated circuit (10) also comprises a resynchronizing module (6) having a clock input (clk) for receiving the output signal (CKN0) from said phase shifter (5), a data input (data) for receiving said frequency-divided signal, an output for supplying a signal (CKREF0) which is identical to the data signal (data) at said data input and is synchronized with the signal (CKN0) at said clock input (clk).

2. An integrated circuit as claimed in claim 1, **characterized in that** said resynchronizing module (6) comprises:
- a first D-type flip-flop (63) having a clock input (CP) connected to said clock input (clk) via an inverter (61), a data input (D) connected to said data input (data), and an output (Q) for supplying an output signal (Q1),
- a second D-type flip-flop (65) having an input (CP) connected to the clock input (CP) of said first flip-flop (63) via an inverter (62), a data input (D), and an output (Q) for supplying said signal (CKREF0),
- a multiplexer (64) which is controllable by a digital phase-control input (d-Ph) for applying either the data input signal (data) or the output signal (Q1) from the first flip-flop (63) to the data input (D) of the second flip-flop (65).

3. An integrated circuit as claimed in claim 1, **characterized in that** the output signal of the oscillator (3) comprises a principal signal (P1) and an annex signal (P2) shifted in phase by π/2 with respect to the principal signal (P1), said phase shifter (5) comprising:
a) a first multiplier (20) for multiplying said principal signal (P1) by a first control word (C),
b) a second multiplier (30) for multiplying said annex signal (P2) by a second control word (S),
c) an adder (40) for adding the output signals of said first and second multiplier (20, 30), said first and second control word (C, S) having such values that the sum of their squares is constant.

4. An integrated circuit as claimed in claim 3, **characterized in that**, with the format of the control words being N bits, each multiplier (20, 30) comprises:
- a switching stage (21) consisting of (N-1) switches each controlled by means of one of (N-1) bits of said control words (C, S),
- an adder (22) for adding the signals controlled by said switches,
- an inversion module (23) connected to the output of the adder (22) and controlled by the residual bit,
- (N-1) amplifiers (24) each arranged at the input of a switch, the gain of each amplifier being proportional to weights, in the control word (C, S), of the bit controlling the corresponding switch.

## Patentansprüche

1. Integrierte Schaltung (10) mit einem Schaltkreis (7) mit einer Phasenregelschleife, wobei der besagte Schaltkreis (7) enthält:
- Einen Oszillator (3), ausgestattet mit einem Ausgang für die Ausgabe eines Ausgangssignals mit regelbarer Frequenz über eine Regelungsspannung, einem Regeleingang zugeführt,
- einen Frequenzteiler (4), ausgestattet mit einem Eingang, verbunden mit dem Ausgang des Oszillators eines Ausgangs für die Zufuhr eines geteilten Frequenzsignals,
- einem Phasenvergleicher (1), ausgestattet mit einem ersten Eingang, bestimmt für den Erhalt eines Referenzsignals (CKREF), einem zweiten Eingang, verbunden mit dem Ausgang des Frequenzteilers (4), und einem Ausgang, verbunden mit dem Regeleingang des Oszillators (3) über einen Filter (2),
- einen Phasenschieber (5), ausgestattet mit einem Eingang, verbunden mit dem Ausgang des Oszillators (3) für die Ausgabe an seinem Ausgang eines Signals (CKN0), in Bezug auf das Signal an seinem Eingang in der Phase verschoben,
**dadurch gekennzeichnet, dass**:
- Der Phasenschieber (5) ausgestattet ist mit einer Klemme für den Erhalt eines digitalen Steuersignals (d-Ph) zur Bestimmung des Werts der Phasenverschiebung, die auf das Signal an seinem Eingang angewandt wird,
- die integrierte Schaltung (10) auch ein Synchronisationsmodul (6) mit einem Uhreingang (clk) für den Erhalt des Ausgangssignals (CKN0) des besagten Phasenschiebers (5) enthält, einen Dateneingang (data) für den Erhalt des besagten geteilten Frequenzsignals, einen Ausgang für die Ausgabe eines Signals (CKREF0), identisch mit dem Datensignal (data) an dem besagten Dateneingang und synchronisiert mit dem Signal (CKN0) an dem besagten Uhreingang (clk).

2. Integrierte Schaltung nach Anspruch, 1 **dadurch gekennzeichnet, dass** das besagte Synchronisationsmodul (6) enthält:
- Ein erstes Flipflop (63) vom Typ D mit einem Uhreingang (CP), verbunden mit dem besagten Uhreingang (clk) über einen Inverter (61), einen Dateneingang (D), verbunden mit dem besagten Dateneingang (data), und einem Ausgang (Q) für die Ausgabe eines Ausgangssignals (Q1),
- ein zweites Flipflop (65) vom Typ D mit einem Eingang (CP), verbunden mit dem Uhreingang (CP) des besagten ersten Flipflops (63) über einen Inverter (62), einen Dateneingang (D) und einen Ausgang (Q) für die Ausgabe des besagten Signals (CKREF0),
- einen Multiplexer (64), steuerbar von einem digitalen Eingang zur Regelung der Phase (d-Ph) für die Zuführung an den Dateneingang (D) des zweiten Flipflops (65) entweder des Signals der Eingangsdaten (data) oder des Ausgangssignals (Q1) des ersten Flipflops (63).

3. Integrierte Schaltung nach Anspruch 1, **dadurch gekennzeichnet, dass** das Ausgangssignal des Oszillators (3) ein Hauptsignal (P1) und ein Nebensignal (P2) enthält, in der Phase um π/2 in Bezug auf das Hauptsignal (P1) verschoben, wobei der besagte Phasenschieber (5) enthält:
a) Einen ersten Multiplizierer (20) zum Multiplizieren des besagtes Hauptsignals (P1) mit einem ersten Steuerwort (C),
b) einen zweiten Multiplizierer (30) zum Multiplizieren des besagten Nebensignals (P2) mit einem zweiten Steuerwort (S),
c) einen Addierer (40) zum Addieren der Ausgangsignale aus dem besagten ersten und zweiten Multiplizierer (20, 30),
wobei die Werte der besagten ersten und zweiten Steuerwörter (C, S) derart sind, dass die Summe ihrer Quadrate konstant ist.

4. Integrierte Schaltung nach Anspruch 3, **dadurch gekennzeichnet, dass** das Format der Steuerwörter N Bits hat und jeder Multiplizierer (20, 30) enthält:
Eine Schaltstufe (21), gebildet aus (N-1) Unterbrechern, gesteuert jeweils mittels einem Bit von den (N-1) Bits der besagten Steuerwörter (C, S),
- einen Addierer (22) zum Addieren der Signale, gesteuert von den besagten Unterbrechern,
- ein Invertermodul (23), verbunden mit dem Ausgang des Addierers (22) und gesteuert von dem verbleibenden Bit,
- (N-1) Verstärker (24), angebracht jeweils am Eingang eines Unterbrechers, wobei die Leistung jedes Verstärkers proportional zum Gewicht des Bits ist, welches den entsprechenden Unterbrecher im Steuerwort steuert (C, S).
